# EUROPEAN PATENT SPECIFICATION

(11) **EP 4 243 079 B1**
(45) Date of publication and mention of the grant of the patent: **06.05.2026**
(21) Application number: 23160090.9
(22) Date of filing: 06.03.2023
(51) Int. Cl.: H10D 30/66, H10D 62/10, H10D 62/17

(54) **SEMICONDUCTOR DEVICE, INTEGRATED CIRCUIT, AND ELECTRONIC DEVICE**
HALBLEITERBAUELEMENT, INTEGRIERTE SCHALTUNG UND ELEKTRONISCHE VORRICHTUNG
DISPOSITIF À SEMI-CONDUCTEUR, CIRCUIT INTÉGRÉ ET DISPOSITIF ÉLECTRONIQUE

(30) Priority: 07.03.2022 CN 202210216617
(43) Date of publication of application: 13.09.2023
(73) Proprietor: Huawei Digital Power Technologies Co., Ltd., Shenzhen, 518043 (CN)
(72) Inventor: JIAO, Chunkun, Shenzhen, 518043 (CN)
(74) Representative: Thun, Clemens

(56) References cited:
- US-A1- 2020 303 540
- US-A1- 2020 373 292
- US-B2- 10 700 182
- US-B2- 10 937 901

## Description

### TECHNICAL FIELD

This application relates to the field of semiconductor technologies, and in particular, to a semiconductor device, an integrated circuit, and an electronic device.

### BACKGROUND

Compared with Si materials, SiC materials have advantages such as a wide band gap, a high critical breakdown electric field, a high thermal conductivity, and a high electron saturation drift velocity. Compared with an insulated gate bipolar transistor (IGBT) made of Si, a metal-oxide-semiconductor field-effect transistor (MOSFET) made of SiC has features such as a high breakdown voltage and a low conduction voltage drop. In addition, due to a unipolar conduction feature, the SiC MOSFET has a higher switching speed, a lower conduction loss, and a lower switching loss than the Si IGBT. Therefore, the SiC MOSFET has replaced the Si IGBT in some fields.

For example, US 10 937 901 B2 refers to: injection control regions of a second conductivity type provided on a charge transport region of a first conductivity type; Main electrode regions of the first conductivity type provided on the injection control regions; insulated gate electrode structures going through the main electrode region and the injection control regions in the depth direction; an injection suppression region going through the main electrode regions and the injection control regions in the depth direction so as to form a pn junction in a path leading to the charge transport region, the injection suppression region including a semiconductor material with a narrower bandgap than a material of the charge transport region; and a contact protection region of the second conductivity type contacting the bottom surface of the injection suppression region.

Further, US 2020/373292 Al refers to a semiconductor device having first second-conductivity-type high-concentration regions, second second-conductivity-type high-concentration regions, third second-conductivity-type high-concentration regions, and fourth second-conductivity-type high-concentration regions. The first connecting regions each connect a portion of each of the first second-conductivity-type high-concentration regions and a portion of each of the second second-conductivity-type high-concentration regions. The second connecting regions each connect a portion of each of the third second-conductivity-type high-concentration regions and a portion of each of the fourth second-conductivity-type high-concentration regions. A ratio of a mathematical area of the first

connecting regions to a mathematical area of the second second-conductivity-type high-concentration regions is greater than a ratio of a mathematical area of the second connecting regions to a mathematical area of the fourth second-conductivity-type high-concentration regions.

Further, US 2020/303540 Al refers to an insulated-gate semiconductor device including: a carrier transport layer of a first conductivity-type made of a semiconductor material having a wider band gap than silicon; a lower buried region of a second conductivity-type buried in an upper portion of the carrier transport layer; a plurality of upper buried regions of the second conductivity-type dispersedly deposited on the lower buried region; an injection control region of the second conductivity-type deposited on the upper buried regions; and an insulated gate structure controlling a surface potential of the injection control region adjacent to a side wall of a trench, wherein the trench has a stripe-like shape, the lower buried region includes a first stripe provided separately from the trench, and the respective upper buried regions are provided at intervals on the first stripe.

Further, US 10 700 182 B2 refers to determining, by using at least one of a processor device and model transistor cells, a set of design parameters for at least one of a transistor cell and a drift structure of a wide band-gap semiconductor device, wherein an on state failure-in-time rate and an off state failure-in-time rate of a gate dielectric of the transistor cell are within a same order of magnitude for a predefined on-state gate-to-source voltage, a predefined off-state gate-to-source voltage, and a predefined off-state drain-to-source voltage.

In comparison with a conventional planar gate MOSFET, a size of a unit cell of the MOSFET may be reduced in a groove gate MOSFET. In this case, density of unit cells of a chip is increased, thereby increasing channel density and improving a through-current capability. The groove gate MOSFET can be used to significantly reduce an on resistance of a device. However, in the groove gate MOSFET, a gate oxide layer is prone to cause electric field concentration at the bottom of or at a corner of a groove. Consequently, the gate oxide layer is broken down at a voltage lower than a rated voltage. This greatly affects a blocking feature of the device. Therefore, providing a solution for reducing the electric field concentration of the gate oxide layer at the bottom of or at the corner of the groove is a technical problem that urgently needs to be resolved by a person skilled in the art.

### SUMMARY

This application provides a semiconductor device, an integrated circuit, and an electronic device, to improve a protection effect of a shielding structure on a gate oxide layer, reduce electric field concentration of the gate oxide layer, and increase a breakdown voltage of the semiconductor device, thereby improving reliability and device features of the semiconductor device. This problem is solved by the subject matter of the independent claim 1. Further implementation forms are provided in the dependent claims.

In a first aspect a semiconductor device is provided, the semiconductor device comprising:
- an n-type semiconductor substrate;
- a drift layer, wherein the drift layer is disposed on a surface of the semiconductor substrate;
- a semiconductor layer, wherein the semiconductor layer is disposed on a surface that is of the drift layer and that is away from the semiconductor substrate, and comprises a source region and a well region, the source region is an n-type semiconductor region, and the source region is exposed on a side that is of the semiconductor layer and that is away from the drift layer;
- a groove, wherein an opening of the groove is located on a surface that is of the semiconductor layer and that is away from the drift layer, a gate is disposed in the groove, and a gate oxide layer is disposed between the gate and a surface of the groove;
- a p-type shielding structure, wherein the shielding structure is disposed at the drift layer and is used to protect the gate oxide layer at the bottom of the groove, wherein the well region is separately in contact with the shielding structure and the source region and a depth of the shielding structure is greater than a depth of the groove, wherein the shielding structure comprises a plurality of first shielding structures and a plurality of second shielding structures, each of the first shielding structures extends in a first direction, each of the second shielding structures extends in a second direction, the first direction intersects with the second direction and the first direction and the second direction are located in a plane parallel to the surface of the semiconductor substrate, and the plurality of first shielding structures and the plurality of second shielding structures are disposed in a grid shape, wherein each of the plurality of the first shielding structures and each of the plurality of the second shielding structures comprises a first shielding portion and a second shielding portion,
   ∘ wherein the first shielding portion extends in a fifth direction, and the fifth direction is perpendicular to the first direction and the second direction, and the first shielding portion has at least one side facing the gate oxide layer,
   ∘ the second shielding portion is located at an end portion of a side that is of the first shielding portion and that faces the semiconductor substrate, and the second shielding portion extends in a direction parallel to the surface of the semiconductor substrate to form a protruding edge of the first shielding portion;
- a source disposed on the side that is of the semiconductor layer and that is away from the drift layer, and in contact with the source region and a gate insulation layer; and
- a drain disposed on a side that is of the semiconductor substrate and that is away from the drift layer.

In this way, the shielding structure may provide protection around a gate oxide layer in a groove located in each lattice region, to better reduce electric field concentration of the gate oxide layer and increase a breakdown voltage of the semiconductor device, thereby improving reliability and device features of the semiconductor device.

In a specific technical solution, to implement grid disposing of the first shielding structures and the second shielding structures, the first shielding structure may be bar-shaped, and the plurality of first shielding structures may be parallel to each other and arranged at spacings of a first specified distance; and similarly, the second shielding structure is bar-shaped, and the plurality of second shielding structures may be parallel to each other and arranged at spacings of a second specified distance. In this way, the first shielding structures and the second shielding structures are staggered to form a grid-shaped structure.

The groove may include a plurality of first grooves and a plurality of second grooves. The first groove extends in a third direction. The second groove extends in a fourth direction. The third direction intersects with the fourth direction. The plurality of first grooves and the plurality of second grooves are disposed in a grid shape. In this technical solution, the groove in the semiconductor device may have a relatively large area, to increase a channel area of the semiconductor device. Therefore, a resistance is relatively small and a current is relatively large in the semiconductor device, to improve the performance of the semiconductor device.

Specifically, the third direction may be parallel to the first direction, and the fourth direction may be parallel to the second direction. In other words, the first groove is parallel to the first shielding structure, and the second groove is parallel to the second shielding structure. In this technical solution, the shielding structure may be symmetrically disposed on the peripheral side of the groove, so that a protection effect is relatively symmetric and uniform, and an electric field of the gate oxide layer of the groove is relatively uniform.

When the shielding structure and the groove are specifically disposed, at least one first shielding structure may be disposed between any two adjacent first grooves, and at least one second shielding structure may be disposed between any two adjacent second grooves. According to this technical solution, any two first grooves are not directly adjacent to each other, and similarly, any two second grooves are not adjacent to each other, to reduce the electric field concentration of the gate oxide layer in the groove.

In a specific technical solution, the first groove and the first shielding structure may be sequentially disposed at spacings, and the second groove and the second shielding structure may be sequentially disposed at spacings.

The first direction intersects with the second direction. Specifically, the first direction may be perpendicular to the second direction, so that the first shielding structure and the second shielding structure are perpendicular to each other. In this case, a lattice region formed by the first shielding structures and the second shielding structures is a rectangle and has a relatively regular shape. The lattice region formed by the first shielding structures and the second shielding structures may be alternatively a square. In this case, the shielding structure has relatively good symmetry, so that a protection effect is relatively uniform, and an electric field of the gate oxide layer in the groove is relatively uniform.

The semiconductor layer may further includes a first semiconductor region. Specifically, the first semiconductor region is a p-type semiconductor region, the well region is also a p-type semiconductor region, and a doping concentration of the first semiconductor region is greater than a doping concentration of the shielding structure. The well region is separately in contact with the shielding structure, the source region, and the first semiconductor region. The first semiconductor region is further in contact with the source. Therefore, the shielding structure, the well region, the first semiconductor region, and the source are sequentially connected, to implement grounding of the shielding structure. The well region is in contact with the source region to form a PN junction. The first semiconductor region is in contact with the source. The first semiconductor region connects the well region to the source region. In this case, the PN junction of the well region and the source region is short-circuited, to prevent the PN junction from being connected.

When the first semiconductor region is specifically disposed, a specific location of the first semiconductor region is not limited. In a technical solution, an orthographic projection of the first semiconductor region on the semiconductor substrate may coincide with an orthographic projection of an overlapping region between the first shielding structure and the second shielding structure on the semiconductor substrate. In this embodiment, the first semiconductor region may also be in full contact with the source region on a peripheral side, and the source region is on the entire peripheral side of the first semiconductor region. Therefore, even if a location of a mask is offset during preparation of the first semiconductor region, the first semiconductor region may still be in contact with the source region and the source.

In another technical solution, an orthographic projection of the first semiconductor region on the semiconductor substrate coincides with an orthographic projection of the shielding structure on the semiconductor substrate. In this solution, the first semiconductor region and the shielding structure may be prepared by using a one-stage mask process through adjusting a power and a parameter of ion implantation, to simplify the preparation process of the semiconductor device. Certainly, in the technical solution of this application, the first semiconductor region may also be in full contact with the source region on the peripheral side, and the source region is on the entire peripheral side of the first semiconductor region. Therefore, even if a location of a mask is offset during preparation of the first semiconductor region, the first semiconductor region may still be in contact with the source region and the source.

A doping concentration of the well region is less than a doping concentration of the first semiconductor region. Therefore, it can be ensured that a p-type doping concentration of the well region is not excessively high, thereby ensuring that a channel can be opened to increase a channel area.

The semiconductor device further includes a current spreading layer. The current spreading layer is an n-type semiconductor region. A doping concentration of the current spreading layer is greater than a doping concentration of the drift layer, and is less than a doping concentration of the source region. The current spreading layer is located at a location at which the drift layer is adjacent to the semiconductor layer. The current spreading layer has a specific thickness. Specifically, a distance between the semiconductor substrate and a surface that is of the current spreading layer and that faces the semiconductor substrate is less than a distance between the semiconductor substrate and a surface that is of the groove and that faces the semiconductor substrate, so that the current spreading layer can wrap the bottom of the groove. The current spreading layer in this embodiment may be used to reduce a spread current of the drift layer at an upper end.

According to a second aspect, an integrated circuit is provided that comprises a circuit board and the semiconductor device according to the first aspect or its implementation forms. According to a third aspect, an electronic device comprising a housing and the integrated circuit according to the second aspect are provided, wherein the integrated circuit is disposed in the housing.

### BRIEF DESCRIPTION OF DRAWINGS

FIG. 1 is a schematic diagram of a structure of a semiconductor device according to an embodiment not being part of, but useful to understand the present invention of this application;
FIG. 2 is a schematic diagram of a cross-sectional structure along a line A-A in FIG. 1;
FIG. 3 is a schematic diagram of another cross-sectional structure along a line A-A in FIG. 1;
FIG. 4 is a schematic diagram of another cross-sectional structure along a line A-A in FIG. 1;
FIG. 5 is a schematic diagram of another cross-sectional structure along a line A-A in FIG. 1;
FIG. 6 is a schematic diagram of another cross-sectional structure along a line A-A in FIG. 1;
FIG. 7 is a schematic diagram of another cross-sectional structure along a line A-A in FIG. 1;
FIG. 8 is a schematic diagram of another structure of a semiconductor device according to an embodiment being part of the present invention of this application;
FIG. 9 is a schematic diagram showing an orthographic projection relationship of a groove, a shielding structure, a first semiconductor region, and a source region of a semiconductor device on a semiconductor substrate according to an embodiment of this application;
FIG. 10 is a schematic diagram showing an orthographic projection relationship of a groove, a shielding structure, a first semiconductor region, and a source region of another semiconductor device on a semiconductor substrate according to an embodiment of this application;
FIG. 11 is a schematic diagram of another structure of a semiconductor device according to an embodiment being part of the present invention.
FIG. 12 shows a preparation method of a semiconductor device according to an embodiment not forming part of but useful to understand the present invention; and
FIG. 13 shows another preparation method of a semiconductor device according to an embodiment not forming part of but useful to understand the present invention.

### Descriptions of reference numerals:

| | | | |
|---|---|---|---|
| 1. | Source | 2. | Semiconductor layer |
| 21. | Source region | 22. | First semiconductor region |
| 23. | Well region | 3. | Gate insulation layer |
| 4. | Groove | 41. | Gate |
| 42. | Gate oxide layer | 43. | First groove |
| 44. | Second groove | 45. | Second common structure |
| 5. | Drift layer | 6. | Semiconductor substrate |
| 7. | Drain | 8. | Shielding structure |
| 81. | First shielding structure | 82. | Second shielding structure |
| 83. | First common structure | 84. | First shielding portion |
| 85. | Second shielding portion | 9. | Current spreading layer |

### DESCRIPTION OF EMBODIMENTS

To make objectives, technical solutions, and advantages of this application clearer, this application is further described in detail below with reference to the accompanying drawings. However, example embodiments may be implemented in a plurality of forms and should not be construed as being limited to the embodiments described herein, but instead, these embodiments are provided to make this application thorough and complete, and to fully convey the concept of the example embodiments to a person skilled in the art. The same reference numerals denote the same or similar structures in the accompanying drawings, and therefore repeated descriptions thereof are omitted. Expressions of locations and directions in this application are all described by using the accompanying drawings as an example. However, changes may be made according to a requirement, and the changes fall within the protection scope of this application. The accompanying drawings in this application are merely used to illustrate a relative location relationship and do not represent a true scale.

It should be noted that specific details are set forth in the following description for full understanding of this application. However, this application can be implemented in other manners different from those described herein, and a person skilled in the art can make similar inferences without departing from the connotation of this application. Therefore, this application is not limited to the specific embodiments disclosed below. Subsequent descriptions in this specification are embodiments of this application, and the descriptions are intended to describe general principles of this application, but are not intended to limit the scope of this application. The protection scope of this application is subject to the appended claims.

To facilitate understanding of a semiconductor device, an integrated circuit, and an electronic device provided in the embodiments of this application, an application scenario of the semiconductor device, the integrated circuit, and the electronic device is first described below. A metal-oxide-semiconductor field-effect transistor is a field-effect transistor (FET) that can be widely used in an analog circuit and a digital circuit. The field-effect transistor can work under conditions of a very small current and a very low voltage. A manufacturing process of the field-effect transistor can conveniently integrate many field-effect transistors. Therefore, the field-effect transistor is widely applied in a large-scale integrated circuit. For example, the field-effect transistor may be applied to fields such as a switch-mode regulated power supply, a power amplifier, an electric vehicle-mounted power supply, a photovoltaic inverter, a server power supply, and rail transport.

It should be noted that, in this application, a layer and a region with a modifier of n indicate that electrons are majority carriers; and a layer and a region with a modifier of p indicate that electron holes are majority carriers. In addition, a symbol "+" marked after n or p indicates that a layer or a region marked with + has a doping concentration greater than that of a layer or region without being marked with +. Herein, n or p with the same quantity of "+"s indicates a similar doping concentration that is not limited to the same doping concentration. Further, "-" marked after n or p indicates that a layer or a region marked with - has a doping concentration less than that of a layer or region without being marked with -. Herein, n or p with the same quantity of "-"s indicates a similar doping concentration that is not limited to the same doping concentration.

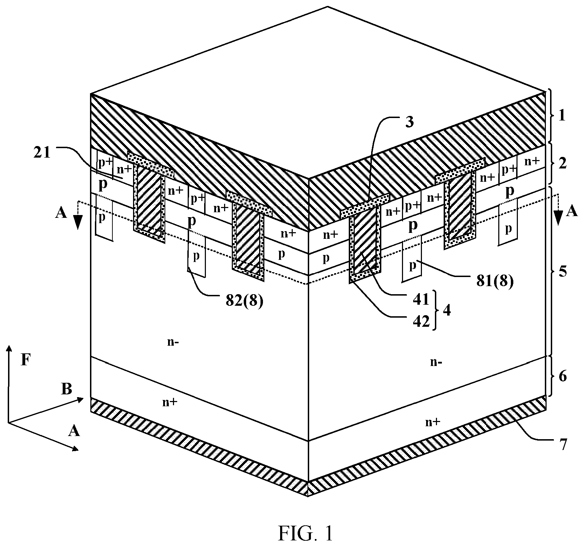

FIG. 1 is a schematic diagram of a structure of a semiconductor device according to an embodiment not forming part of but useful to understand the present invention. As shown in FIG. 1, the semiconductor device includes a source 1, a semiconductor layer 2, gate insulation layers 3, a groove 4, a drift layer 5 (n-), an n-type semiconductor substrate 6 (n+), and a drain 7. The semiconductor substrate 6 (n+) is disposed on a surface of the drain 7. The drift layer 5 (n-) is an n-type semiconductor region, is disposed on a surface on a side that is of the semiconductor substrate 6 (n+) and that is away from the drain 7, and is mainly used to carry a high voltage. The semiconductor layer 2 is disposed on a surface on a side that is of the drift layer 5 (n-) and that is away from the semiconductor substrate 6 (n+), and includes a source region 21 (n+). The source region 21 (n+) is an n-type semiconductor region. The source region 21 (n+) is exposed on a side that is of the semiconductor layer 2 and that is away from the drift layer 5 (n-). An opening of the groove 4 is located on a surface that is of the semiconductor layer 2 and that is away from the drift layer 5 (n-). A gate 41 is disposed in the groove 4. A gate oxide layer 42 is disposed between the gate 41 and a surface of the groove 4. In addition, the gate insulation layer 3 covers the opening of the groove 4, and exposes the source region 21 (n+), so that the gate 41 is wrapped by the gate oxide layer 42 and the gate insulation layer 3. The source 1 is disposed on a surface on a side that is of the semiconductor layer 2 and that is away from the drift layer 5 (n-), and is in contact with the source region 21 (n+) and the gate insulation layer 3. The gate 41 is wrapped by the gate oxide layer 42 and the gate insulation layer 3, to implement isolation between the gate 41 and the source 1. In a specific embodiment, the semiconductor device may be a MOSFET. The MOSFET may be turned on or off through applying a gate bias voltage to the gate 41 of the MOSFET. When the gate bias voltage is higher than a threshold voltage, the MOSFET is in an on state, and a current is conducted through a channel of the MOSFET. When the gate bias voltage is lower than the threshold voltage, conduction of the current through the channel is stopped. For example, for an n-type MOSFET device, when an applied gate bias voltage is higher than the threshold voltage, a conductive n-type inversion layer is formed in a p-type channel region of the device. The n-type inversion layer is connected to the source 1 and the drain 7 of the MOSFET. In this way, the device is connected, and majority carriers can be transmitted. The gate oxide layer 42 is prone to cause electric field concentration at the bottom of or a corner of the groove 4. Consequently, the gate oxide layer 42 is broken down at a voltage lower than a rated voltage. This greatly affects a blocking feature of the semiconductor device.

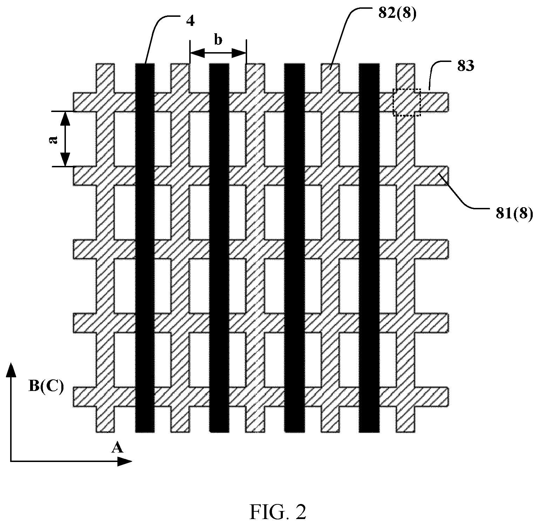

Still with reference to FIG. 1, the semiconductor device further includes a p-type shielding structure 8 (p). The p-type shielding structure 8 (p) is disposed at the drift layer 5 (n-). The shielding structure 8 (p) may be used to reduce electric field strength of the gate oxide layer 42, so that the semiconductor device is broken down only at a voltage higher than the rated voltage. Therefore, the semiconductor device has a good blocking feature, and reliability and device features of the semiconductor device are improved. FIG. 2 is a schematic diagram of a cross-sectional structure along a line A-A in FIG. 1, and mainly shows a projection relationship between the groove 4 and the shielding structure 8 (p) on a plane at which the semiconductor substrate 6 (n+) is located. With reference to FIG. 1 and FIG. 2, the shielding structure 8 (p) includes a plurality of first shielding structures 81 (p) and a plurality of second shielding structures 82 (p). The first shielding structure 81 (p) extends in a first direction A. The second shielding structure 82 (p) extends in a second direction B. The first direction A intersects with the second direction B. The plurality of first shielding structures 81 (p) and the plurality of second shielding structures 82 (p) are disposed in a grid shape. In this embodiment, the first shielding structures 81 (p) and the second shielding structures 82 (p) disposed in the grid shape may form a plurality of lattice regions, and the shielding structure 8 (p) exists on a peripheral side of each lattice region. In this way, the shielding structure 8 (p) may provide protection around the gate oxide layer 42 in the groove 4 located in each lattice region, to better reduce electric field concentration of the gate oxide layer 42 and increase a breakdown voltage of the semiconductor device, thereby improving reliability and device features of the semiconductor device.

It should be noted that, when the first shielding structures 81 (p) and the second shielding structures 82 (p) are specifically disposed, an overlapping region between the first shielding structure 81 (p) and the second shielding structure 82 (p) is a first common structure 83. In other words, it may be considered that the first shielding structures 81 (p) and the second shielding structures 82 (p) are an integrated structure, and the first common structure 83 belongs to the first shielding structure 81 (p) and also belongs to the second shielding structure 82 (p). In this embodiment not forming part of but useful to understand the present invention, when the shielding structure 8 (p) is actually prepared, the first shielding structures 81 (p) and the second shielding structures 82 (p) may be formed through one-stage masking, namely, a one-stage process, to simplify a preparation process of the shielding structure 8 (p).

A depth of the shielding structure 8 (p) is greater than a depth of the groove 4. Specifically, a distance between the semiconductor substrate 6 (n+) and a surface that is of the shielding structure 8 (p) and that faces the semiconductor substrate 6 (n+) is less than the distance between the semiconductor substrate 6 (n+) and a surface that is of the groove 4 and that faces the semiconductor substrate 6 (n+). In other words, the depth of the shielding structure 8 (p) is greater than the depth of the groove 4. In this embodiment, the shielding structure 8 (p) can well protect the gate oxide layer 42 in the groove 4, to reduce a case of the electric field concentration of the gate oxide layer 42.

When the shielding structure 8 (p) is specifically disposed, an extension direction of the shielding structure 8 (p) and the formed grid shape are not limited. However, the shielding structure 8 (p) may be symmetrically disposed on a peripheral side of the groove 4, to improve symmetry of the semiconductor device.

Certainly, in another embodiment, not forming part of but useful to understand the present invention, the first shielding structures 81 (p) and the second shielding structures 82 (p) may be alternatively formed through two-stage masking, namely, a two-stage process. For example, a first mask is formed, and the first shielding structure 81 (p) is formed by using the first mask. Then, the first mask is removed, a second mask is formed, and the second shielding structure 82 (p) is formed by using the second mask. In this embodiment, the first common structure 83 may be prepared in any one stage of the two-stage process. For example, if the first common structure 83 is formed by using the first mask, a region in which the first common structure 83 is located does not need to be exposed, and the second shielding structure 82 (p) is formed with the region of the first common structure 83 removed in the second mask.

When the first shielding structures 81 (p) and the second shielding structures 82 (p) are prepared by using the two-stage process, a depth of the first shielding structure 81 (p) is alternatively different from a depth of the second shielding structure 82 (p). In other words, a distance between the semiconductor substrate 6 (n+) and a surface that is of the first shielding structure 81 (p) and that faces the semiconductor substrate 6 (n+) **is** different from a distance between the semiconductor substrate 6 (n+) and a surface that is of the second shielding structure 82 (p) and that faces the semiconductor substrate 6 (n+). In this case, the first common structure 83 and one of the first shielding structure 81 (p) or the second shielding structure 82 (p) have the same depth.

Still with reference to FIG. 2, in a specific embodiment, the first shielding structure 81 (p) is bar-shaped, and the plurality of first shielding structures 81 (p) are parallel to each other and arranged at spacings of a first specified distance a. Similarly, the second shielding structure 82 (p) is also bar-shaped, and the plurality of second shielding structures 82 (p) are parallel to each other and arranged at spacings of a second specified distance b. In this way, the first shielding structures 81 (p) and the second shielding structures 82 (p) are staggered to form a grid-shaped structure.

In a specific embodiment, the first specified distance a may be the same as or different from the second specified distance b. This is not limited in this application. In a specific embodiment, the first specified distance a may be equal to the second specified distance b. In this case, the lattice region in the grid-shaped structure formed by the first shielding structures 81 (p) and the second shielding structures 82 (p) is a rhombus or a square and has a relatively regular shape. Certainly, the first specified distance a may be alternatively different from the second specified distance b according to a specific requirement for a structure of the semiconductor device.

Still with reference to FIG. 2, in a specific embodiment, the first direction A is perpendicular to the second direction B. In this case, the lattice region formed by the first shielding structures 81 (p) and the second shielding structures 82 (p) is a rectangle and has a relatively regular shape. In addition, when the first specified distance a is equal to the second specified distance b, the lattice region formed by the first shielding structures 81 (p) and the second shielding structures 82 (p) is a square. The shielding structure 8 (p) has relatively good symmetry, so that a protection effect is relatively uniform, and an electric field of the gate oxide layer 42 of the groove 4 is relatively uniform.

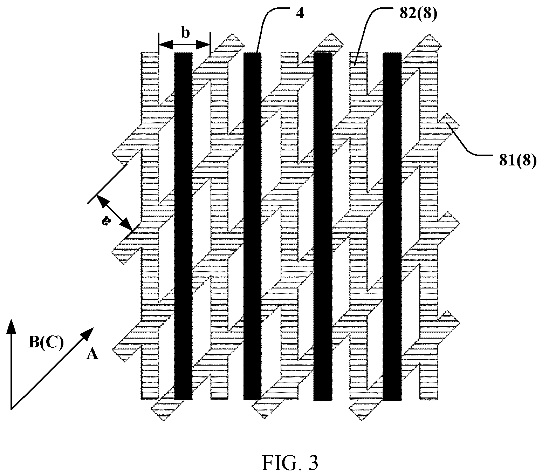

FIG. 3 is a schematic diagram of another cross-sectional structure along a line A-A in FIG. 1, and mainly shows another projection relationship between the groove 4 and the shielding structure 8 (p) on a plane at which the semiconductor substrate 6 (n+) is located. With reference to FIG. 3, in a specific embodiment, the first direction A may be alternatively not perpendicular to the second direction B. In this case, the lattice region formed by the first shielding structures 81 (p) and the second shielding structures 82 (p) is a parallelogram. When the first specified distance a is equal to the second specified distance b, the lattice region formed by the first shielding structures 81 (p) and the second shielding structures 82 (p) is a rhombus.

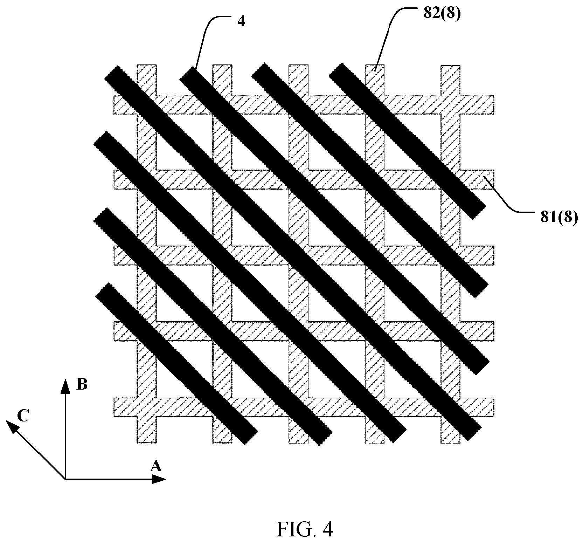

FIG. 4 is a schematic diagram of another cross-sectional structure along a line A-A in FIG. 1, and mainly shows another projection relationship between the groove 4 and the shielding structure 8 (p) on a plane at which the semiconductor substrate 6 (n+) is located. With reference to FIG. 2 to FIG. 4, in a specific embodiment, when the groove 4 is prepared, the plurality of grooves 4 extend in a sixth direction C. In other words, the grooves 4 are arranged in a bar shape and have consistent extension directions. In a specific embodiment, the plurality of grooves 4 may be alternatively parallel to each other and arranged at spacings of a specified distance, so that the semiconductor device has relatively good symmetry and uniformity.

As shown in FIG. 2 and FIG. 3, the sixth direction C may be parallel to the first direction A or the second direction B. Alternatively, the sixth direction C may be parallel to neither of the first direction A and the second direction B. In this case, as shown in FIG. 4, a specific included angle exists between the sixth direction C and each of the first direction A and the second direction B. Further, the included angle between the sixth direction C and the first direction A may be the same as the included angle between the sixth direction C and the second direction B, to improve the symmetry of the semiconductor device.

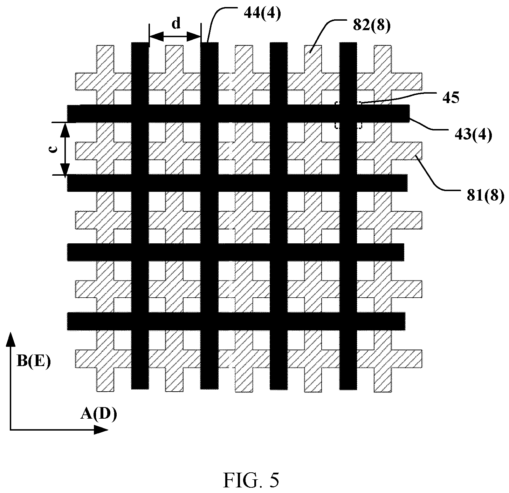

FIG. 5 is a schematic diagram of another cross-sectional structure along a line A-A in FIG. 1, and mainly shows another projection relationship between the groove 4 and the shielding structure 8 (p) on a plane at which the semiconductor substrate 6 (n+) is located. As shown in FIG. 5, the groove 4 may include a plurality of first grooves 43 and a plurality of second grooves 44. The first groove 43 extends in a third direction D. The second groove 44 extends in a fourth direction E. The third direction D intersects with the fourth direction E. The first grooves 43 and the second grooves 44 are disposed in a grid shape. In this solution, the groove 4 in the semiconductor device may have a relatively large area, to increase a channel area of the semiconductor device. Therefore, a resistance is relatively small and a current is relatively large in the semiconductor device, to improve performance of the semiconductor device.

It should be noted that, when the first grooves 43 and the second grooves 44 are specifically disposed, an overlapping region between the first groove 43 and the second groove 44 is a second common structure 45. In other words, it may be considered that the first grooves 43 and the second grooves 44 are an integrated structure, and the second common structure 45 belongs to the first groove 43 and also belongs to the second groove 44. In this embodiment, when the groove is actually prepared, the first grooves 43 and the second grooves 44 may be formed by using a one-stage etching process, to simplify a preparation process of the groove 4.

Certainly, in another embodiment, not forming part of but useful to understand the present invention, the first grooves 43 and the second grooves 44 may be alternatively formed by using a two-stage etching process. For example, a third mask is formed, and the first groove 43 is formed through etching the third mask. Then, the third mask is removed, a fourth mask is formed, and the second groove 44 is formed by using the fourth mask. In this embodiment, the second common structure 45 may be prepared in any one stage of the two-stage process. For example, if the second common structure 45 is formed in a first time of etching, a region in which the second common structure 45 is located does not need to be exposed, and the second groove 44 is formed with the region of the second common structure 45 removed in the second time of etching.

When the first grooves 43 and the second grooves 44 are prepared by using the two-stage process, a depth of the first groove 43 may be alternatively different from a depth of the second groove 44. In other words, a distance between the semiconductor substrate 6 (n+) and a surface that is of the first groove 43 and that faces the semiconductor substrate 6 (n+) may be different from a distance between the semiconductor substrate 6 (n+) and a surface that is of the groove 4 and that faces the semiconductor substrate 6 (n+). In this case, the second common structure 45 and one of the first groove 43 and the second groove 44 have the same depth.

Still with reference to FIG. 5, in a specific embodiment, the first groove 43 is bar-shaped, and the plurality of first grooves 43 are parallel to each other and arranged at spacings of a third specified distance c. Similarly, the second groove 44 is also bar-shaped, and the plurality of second grooves 44 are parallel to each other and arranged at spacings of a fourth specified distance d. In this way, the first groove 43 and the second groove 44 are staggered to form a grid-shaped structure.

In a specific embodiment, the third specified distance c may be the same as or different from the fourth specified distance d. This is not limited in this application. In a specific embodiment, the third specified distance c may be equal to the fourth specified distance d. In this case, the lattice region in the grid-shaped structure formed by the first grooves 43 and the second grooves 44 is a rhombus or a square and has a relatively regular shape. Certainly, the third specified distance c may be different from the fourth specified distance d according to a specific requirement for a structure of the semiconductor device.

Still with reference to FIG. 5, in a specific embodiment, the third direction D is perpendicular to the fourth direction E. In this case, the lattice region formed by the first grooves 43 and the second grooves 44 is a rectangle and has a relatively regular shape. In addition, when the third specified distance c is equal to the fourth specified distance d, the lattice region formed by the first grooves 43 and the second grooves 44 is a square. The groove 4 has relatively good symmetry, so that a protection effect is relatively uniform, and an electric field of the gate oxide layer 42 of the groove 4 is relatively uniform.

As shown in FIG. 5, in a specific embodiment, the first direction A is the same as the third direction D, and the second direction B is the same as the fourth direction E. In other words, an extension direction of the first groove 43 is the same as an extension direction of the first shielding structure 81 (p), and the first groove 43 is parallel to the first shielding structure 81 (p); and an extension direction of the second groove 44 is the same as an extension direction of the second shielding structure 82 (p), and the second groove 44 is parallel to the second shielding structure 82 (p). In this embodiment, the shielding structure may be symmetrically disposed on a peripheral side of the groove, so that the protection effect is relatively symmetric and uniform, and the electric field of the gate oxide layer 42 of the groove 4 is relatively uniform.

In a specific embodiment, at least one first shielding structure 81 (p) may be disposed between any two adjacent first grooves 43, and at least one second shielding structure 82 (p) may be disposed between any two adjacent second grooves 44. Certainly, in a specific embodiment, the first groove 43 and the first shielding structure 81 (p) may be sequentially disposed at spacings, and the second groove 44 and the second shielding structure 82 (p) may be sequentially disposed at spacings. According to this technical solution, any two first grooves 43 are not directly adjacent to each other, and similarly, any two second grooves 44 are not adjacent to each other, to reduce the electric field concentration of the gate oxide layer 42 in the groove 4.

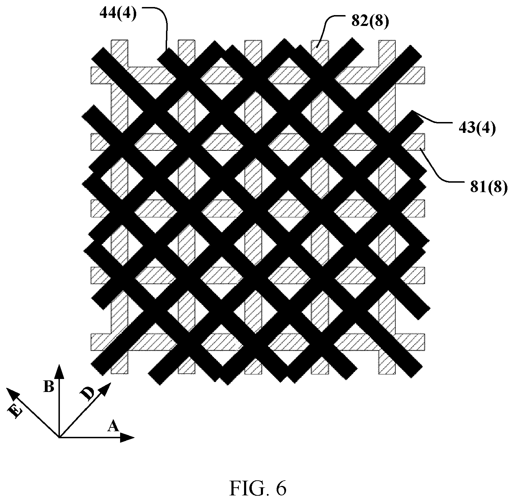

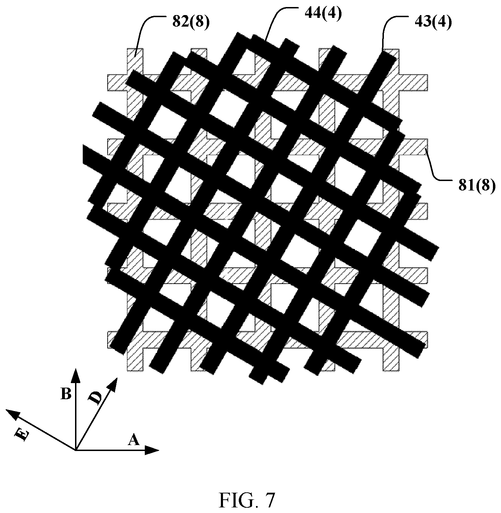

In another embodiment, the third direction D may be alternatively different from the first direction A, and the fourth direction E may be alternatively different from the second direction B. However, a first included angle between the third direction D and the first direction A is not limited, a second included angle between the fourth direction E and the second direction B is also not limited, and the first included angle may be the same as or different from the second included angle. This is not limited in this application. For example, in the embodiments shown in FIG. 6 and FIG. 7, the first included angle is the same as the second included angle. The first included angle and the second included angle in FIG. 6 are the same and are both 45°. The first included angle and the second included angle in FIG. 7 are also the same and are both 30°.

Still with reference to FIG. 1, the shielding structure 8 (p) extends in a fifth direction F. The fifth direction F is perpendicular to the first direction A and the second direction B. In other words, the shielding structure 8 (p) is a straight line-shaped structure in the fifth direction F, and directly extends in a direction toward the semiconductor substrate 6 (n+). In this solution, a preparation process of the shielding structure 8 (p) is relatively simple. The shielding structure 8 (p) can be prepared through directly performing ion implantation. In this embodiment, it may be considered that the groove 4 also extends in the fifth direction F. In other words, both the groove 4 and the shielding structure 8 (p) extend in the direction toward the semiconductor substrate 6 (n+). In this way, the preparation process of the semiconductor device can also be simplified.

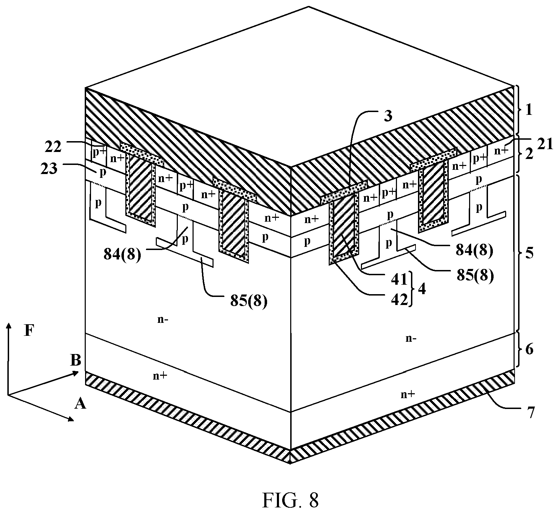

FIG. 8 is a schematic diagram of another structure of a semiconductor device according to an embodiment being part of the present invention. As shown in FIG. 8, in another embodiment, the shielding structure 8 (p) includes a first shielding portion 84 and a second shielding portion 85. The first shielding portion 84 extends in a fifth direction F. The fifth direction F is perpendicular to the first direction A and the second direction B. In other words, the first shielding portion 84 is a straight line-shaped structure in the fifth direction F, and directly extends in a direction toward the semiconductor substrate 6 (n+). The second shielding portion 85 is located at an end portion of a side that is of the first shielding portion 84 and that faces the semiconductor substrate 6 (n+). In a state shown in FIG. 8, the second shielding portion 85 is located at the bottom of the first shielding portion 84. In addition, the second shielding portion 85 extends in a direction parallel to a surface of the semiconductor substrate 6 (n+), and is formed as a protruding edge of the first shielding portion 84. It may be considered that the first shielding portion 84 and the second shielding portion 85 are the shielding structure 8 (p) with an integrated structure, and the shielding structure 8 (p) is bent at the bottom of the gate oxide layer 42 in a direction toward the gate oxide layer 42. In this embodiment, the first shielding portion 84 may be disposed around the gate oxide layer 42 to protect the gate oxide layer 42, thereby reducing a surrounding impact on the gate oxide layer 42 and reducing the electric field concentration of the gate oxide layer 42. The second shielding portion 85 may protect the gate oxide layer 42 in a direction from the gate oxide layer 42 to the semiconductor substrate 6 (n+) (at the bottom of the gate oxide layer 42 in FIG. 8), to reduce a bottom impact on the gate oxide layer 42 and reduce the electric field concentration of the gate oxide layer 42. The shielding structure 8 (p) in this embodiment may form a wrapping structure for the gate oxide layer 42, to effectively shield interference to the gate oxide layer 42 and reduce the electric field concentration of the gate oxide layer 42, thereby improving the reliability of the semiconductor device and prolonging the service life of the semiconductor device.

In a specific technical solution, when there are grooves 4 on two sides of the first shielding portion 84, the second shielding portion 85 may be symmetrically disposed on the two sides of the first shielding portion 84, to protect the gate oxide layer 42 on the two sides. Alternatively, according to an actual product requirement, there may be alternatively second shielding portions on two sides of the first shielding portion 84, but the second shielding portions 85 on the two sides are asymmetrically disposed. For example, if distances between the first shielding portion 84 and the grooves 4 on the two sides of the first shielding portion 84 are different, an extension distance of the second shielding portion 85 is shorter on a side that is of the groove 4 and that is closer to the first shielding portion 84, and an extension distance of the second shielding portion 85 is longer on a side that is of the groove 4 and that is farther from the first shielding portion 84. When there is a groove 4 on only one side of the first shielding portion 84, the second shielding portion 85 may be disposed on only a side that is of the first shielding portion 84 and that faces the groove 4.

Still with reference to FIG. 8, in an embodiment, the semiconductor device includes a first semiconductor region 22 (p+) and a well region 23 (p). The first semiconductor region 22 (p+) and the well region 23(p) are located at the semiconductor layer 2. Specifically, the first semiconductor region 22 (p+) is a p-type semiconductor region, the well region 23 (p) is also a p-type semiconductor region, and a doping concentration of the first semiconductor region 22 (p+) is greater than a doping concentration of the shielding structure 8 (p). The well region 23 (p) is separately in contact with the shielding structure 8 (p), the source region 21 (n+), and the first semiconductor region 22 (p+). The first semiconductor region 22 (p+) is further in contact with the source 1. Therefore, the shielding structure 8 (p), the well region 23 (p), the first semiconductor region, and the source 1 are sequentially connected, to implement grounding of the shielding structure 8 (p). The well region 23 (p) is in contact with the source region 21 (n+) to form a PN junction. A first semiconductor is in contact with the source 1. The first semiconductor region 22 (p+) connects the well region 23 (p) to the source region 21 (n+). In this case, the PN junction of the well region 23 (p) and the source region 21 (n+) is short-circuited, to prevent the PN junction from being connected.

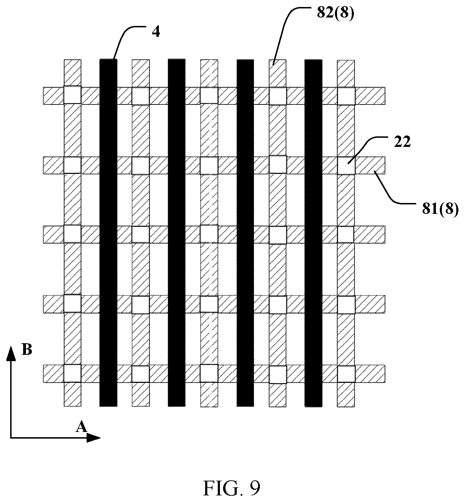

With reference to FIG. 8, in a specific embodiment, the first semiconductor region 22 (p+) and the source region 21 (n+) may be disposed at the same layer, the first semiconductor region and the source region 21 (n+) are sequentially alternately disposed, and the well region 23 (p) is disposed on a side that is of the first semiconductor region 22 (p+) and the source region 21 (n+) and that faces the drift region. FIG. 9 is a schematic top view of a partial structure of a semiconductor device according to an embodiment of this application, and is a schematic diagram showing an orthographic projection relationship of the groove 4, the shielding structure 8 (p), the first semiconductor region 22 (p+), and the source region 21 (n+) on the semiconductor substrate 6 (n+). As shown in FIG. 8 and FIG. 9, when the first semiconductor region 22 (p+) is specifically disposed, an orthographic projection of the first semiconductor region 22 (p+) on the semiconductor substrate 6 (n+) coincides with an orthographic projection of an overlapping region between the first shielding structure 81 (p) and the second shielding structure 82 (p) on the semiconductor substrate 6 (n+). The overlapping region may be understood as the common region in the foregoing embodiments. In this embodiment, the first semiconductor region 22 (p+) may be in full contact with the source region 21 (n+) on a peripheral side, and the source region 21 (n+) is on the entire peripheral side of the first semiconductor region 22 (p+). Therefore, even if a location of a mask is offset during preparation of the first semiconductor region 22 (p+), the first semiconductor region 22 (p+) may still be in contact with the source region 21 (n+) and the source 1.

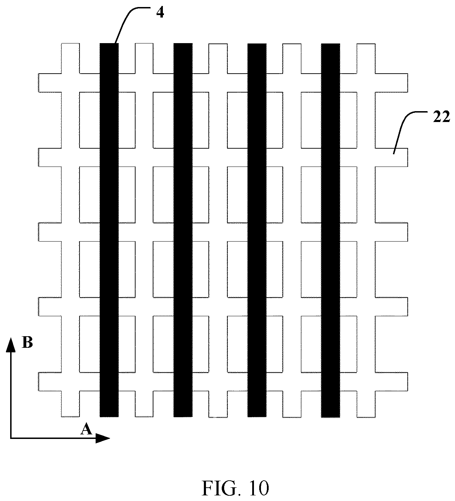

FIG. 10 is a schematic top view of another partial structure of a semiconductor device according to an embodiment of this application, and is a schematic diagram showing an orthographic projection relationship of the groove 4, the shielding structure 8 (p), the first semiconductor region 22 (p+), and the source region 21 (n+) on the semiconductor substrate 6 (n+). As shown in FIG. 10, when the first semiconductor region 22 (p+) is specifically disposed, an orthographic projection of the first semiconductor region 22 (p+) on the semiconductor substrate 6 (n+) may further coincide with an orthographic projection of the shielding structure 8 (p) on the semiconductor substrate 6 (n+). In other words, the first semiconductor region 22 (p+) and the shielding structure 8 (p) have the same shape. In this solution, the first semiconductor regions 22 (p+) and the shielding structure 8 (p) may be prepared by using a one-stage mask process through adjusting a power and a parameter of ion implantation, to simplify the preparation process of the semiconductor device.

Certainly, in another embodiment, the first semiconductor region 22 (p+) may also be irrelevant to the shielding structure 8 (p), provided that the first semiconductor region 22 (p+) can be in contact with each part. This is not limited in this application.

A doping concentration of the well region 23 (p) is less than a doping concentration of the first semiconductor region 22 (p+). In this embodiment, it can be ensured that a p-type doping concentration of the well region 23 (p) is not excessively high, thereby ensuring that a channel can be opened to increase a channel area.

In a specific embodiment, the doping concentration of the well region 23 (p) is less than a doping concentration of the shielding structure 8 (p). Specifically, the doping concentration of the shielding structure 8 (p) may be 10 to 100 times of the doping concentration of the well region 23 (p), to improve shielding performance of the shielding structure.

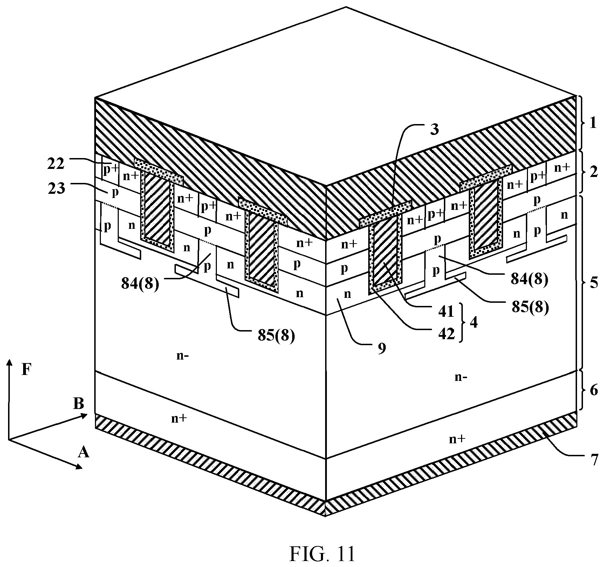

FIG. 11 is a schematic diagram of another structure of a semiconductor device according to an embodiment being part of the present invention. As shown in FIG. 11, in another embodiment, the semiconductor device further includes a current spreading layer 9 (n). The current spreading layer 9 (n) is an n-type semiconductor region. A doping concentration of the current spreading layer 9 (n) is greater than a doping concentration of the drift layer 5 (n-) and is less than a doping concentration of the source region 21 (n+). The current spreading layer 9 (n) is located at the drift layer 5 (n-) and is located at a location at which the drift layer 5 (n-) is adjacent to the semiconductor layer 2. The current spreading layer 9 (n) has a specific thickness. Specifically, a distance between the semiconductor substrate 6 (n+) and a surface that is of the current spreading layer 9 (n) and that faces the semiconductor substrate 6 (n+) is less than a distance between the semiconductor substrate 6 (n+) and a surface that is of the groove 4 and that faces the semiconductor substrate 6 (n+), so that the current spreading layer 9 (n) can wrap the bottom of the groove 4. The current spreading layer 9 (n) in this embodiment may be used to reduce a spread current of the drift layer 5 (n-) at an upper end.

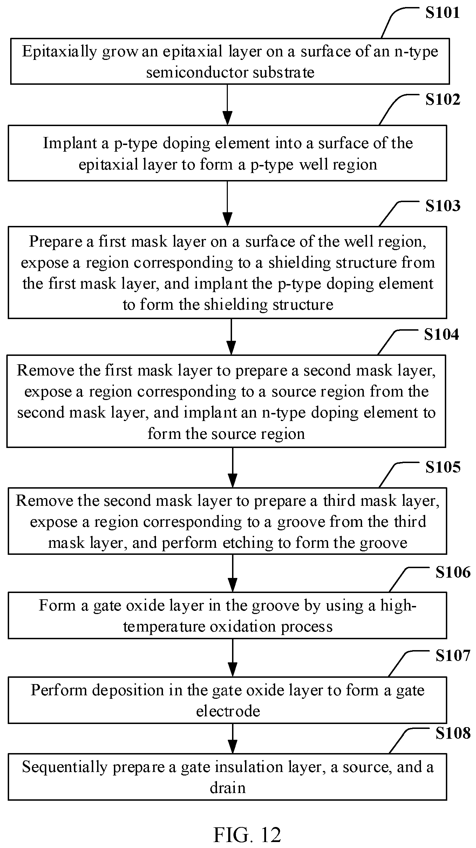

This application further provides two preparation methods for preparing the semiconductor device in the foregoing embodiments not forming part of but useful to understand the present invention. FIG. 12 shows a preparation method of a semiconductor device according to an embodiment not forming part of but useful to understand the present invention. The preparation method specifically includes the following steps:
Step S101: Epitaxially grow an epitaxial layer on a surface of an n-type semiconductor substrate 6 (n+).

Specifically, the semiconductor substrate may be a silicon carbide (SiC) substrate.

Step S102: Implant a p-type doping element into a surface of the epitaxial layer to form a p-type well region.

Step S103: Prepare a first mask layer on a surface of the well region, expose a region corresponding to a shielding structure 8 (p) from of the first mask layer, and implant the p-type doping element to form the shielding structure 8 (p).

A material of the first mask layer is not limited. For example, the material may be any one of silicon dioxide, a polycrystalline silicon layer, a nitride layer, or silicon nitride. A first opening of the first mask layer is formed by using a dry etching process or a wet etching process. The first opening corresponds to a region in which the shielding structure is located. Then, the p-type doping element may be implanted in an ion implantation manner to form the foregoing shielding structure.

Step S104: Remove the first mask layer to prepare a second mask layer, expose a region corresponding to a source region 21 (n+) from the second mask layer, and implant an n-type doping element to form the source region 21 (n+).

A material of the second mask layer is not limited. For example, the material may be any one of silicon dioxide, a polycrystalline silicon layer, a nitride layer, or silicon nitride. A second opening of the second mask layer is formed by using a dry etching process or a wet etching process. The second opening corresponds to a region in which the source region is located. Then, the n-type doping element may be implanted in an ion implantation manner to form the source region.

Step S105: Remove the second mask layer to prepare a third mask layer, expose a region corresponding to a groove 4 from the third mask layer, and perform etching to form the groove 4.

After the second mask layer is removed, ion-activated annealing and surface cleaning may be further performed, to prepare the third mask layer. A material of the third mask layer is not limited. For example, the material may be any one of silicon dioxide, a polycrystalline silicon layer, a nitride layer, or silicon nitride. A third opening of the third mask layer is formed by using a dry etching process or a wet etching process. The third opening corresponds to a region in which the groove is located. Then, the groove may be formed by using the dry etching process.

Step S106: Form a gate oxide layer 42 in the groove 4 by using a high-temperature oxidation process.

Step S107: Perform deposition in the gate oxide layer 42 to form a gate 41.

Step S108: Sequentially prepare a gate insulation layer 3, a source 1, and a drain 7.

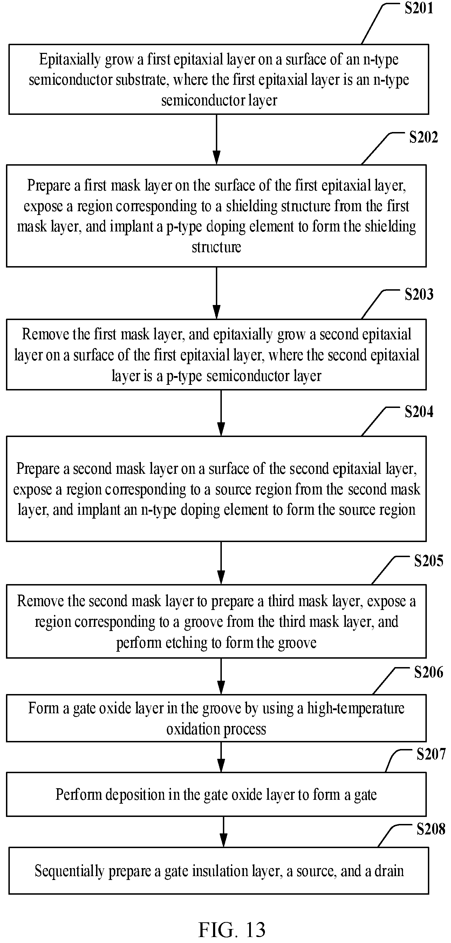

FIG. 13 shows another preparation method of a semiconductor device according to an embodiment not forming part of but useful to understand the present invention. The preparation method includes the following steps:
Step S201: Epitaxially grow a first epitaxial layer on a surface of an n-type semiconductor substrate 6 (n+). The first epitaxial layer is an n-type semiconductor layer 2.

Specifically, the semiconductor substrate may be a silicon carbide (SiC) substrate.

Step S202: Prepare a first mask layer on the surface of the first epitaxial layer, expose a region corresponding to a shielding structure 8 (p) from the first mask layer, and implant a p-type doping element to form the shielding structure 8 (p).

A material of the first mask layer is not limited. For example, the material may be any one of silicon dioxide, a polycrystalline silicon layer, a nitride layer, or silicon nitride. A first opening of the first mask layer is formed by using a dry etching process or a wet etching process. The first opening corresponds to a region in which the shielding structure is located. Then, the p-type doping element may be implanted in an ion implantation manner to form the foregoing shielding structure.

Step S203: Remove the first mask layer, and epitaxially grow a second epitaxial layer on a surface of the first epitaxial layer. The second epitaxial layer is a p-type semiconductor layer 2.

Step S204: Prepare a second mask layer on a surface of the second epitaxial layer, expose a region corresponding to a source region 21 (n+) from the second mask layer, and implant an n-type doping element to form the source region 21 (n+).

A material of the second mask layer is not limited. For example, the material may be any one of silicon dioxide, a polycrystalline silicon layer, a nitride layer, or silicon nitride. A second opening of the second mask layer is formed by using a dry etching process or a wet etching process. The second opening corresponds to a region in which the source region is located. Then, the n-type doping element may be implanted in an ion implantation manner to form the source region.

Step S205: Remove the second mask layer to prepare a third mask layer, expose a region corresponding to a groove 4 from the third mask layer, and perform etching to form the groove 4.

After the second mask layer is removed, ion-activated annealing and surface cleaning may be further performed, to prepare the third mask layer. A material of the third mask layer is not limited. For example, the material may be any one of silicon dioxide, a polycrystalline silicon layer, a nitride layer, or silicon nitride. A third opening of the third mask layer is formed by using a dry etching process or a wet etching process. The third opening corresponds to a region in which the groove is located. Then, the groove may be formed by using the dry etching process.

Step S206: Form a gate oxide layer 42 in the groove 4 by using a high-temperature oxidation process.

Step S207: Perform deposition in the gate oxide layer 42 to form a gate 41.

Step S208: Sequentially prepare a gate insulation layer 3, a source 1, and a drain 7.

Based on the same inventive concept, this application further provides an integrated circuit. The integrated circuit includes a circuit board and the semiconductor device in any one of the foregoing embodiments. The semiconductor device is disposed on the circuit board. The shielding structure 8 (p) in the semiconductor device may provide protection around the gate oxide layer 42, to reduce electric field concentration of the gate oxide layer 42 and increase a breakdown voltage of the semiconductor device, thereby improving reliability and device features of the semiconductor device. In this way, performance of the integrated circuit can be improved, and a service life of the integrated circuit can be prolonged.

Based on the same inventive concept, this application further provides an electronic device. The electronic device includes a housing and the integrated circuit. The integrated circuit is disposed in the housing. Specifically, the integrated circuit may be disposed inside the housing or disposed on a surface of the housing. This is not limited in this application. The integrated circuit of the electronic device has relatively good performance and a relatively long service life, thereby improving the performance of the electronic device and prolonging the service life of the electronic device.

Obviously, a person skilled in the art can make various modifications and variations to this application without departing from the scope of this application. In this way, this application is intended to cover these modifications and variations of this application provided that they fall within the scope of protection defined by the following claims.

## Claims

1. A semiconductor device comprising:
• an n-type semiconductor substrate (6);
• a drift layer (5), wherein the drift layer (5) is disposed on a surface of the semiconductor substrate (6);
• a semiconductor layer (2), wherein the semiconductor layer (2) is disposed on a surface that is of the drift layer (5) and that is away from the semiconductor substrate (2), and comprises a source region (21) and a well region (23), the source region (21) is an n-type semiconductor region, and the source region (21) is exposed on a side that is of the semiconductor layer (2) and that is away from the drift layer (5);
• a groove (4), wherein an opening of the groove (4) is located on a surface that is of the semiconductor layer (2) and that is away from the drift layer (5), a gate (41) is disposed in the groove (4), and a gate oxide layer (42) is disposed between the gate (41) and a surface of the groove (4);
• a p-type shielding structure (81(8), 82(8)), wherein the shielding structure (81(8), 82(8)) is disposed at the drift layer (5) and is used to protect the gate oxide layer (42) at the bottom of the groove (4), wherein the well region (23) is separately in contact with the shielding structure (81(8), 82(8)) and the source region (21) and a depth of the shielding structure (81(8), 82(8)) is greater than a depth of the groove (4), wherein the shielding structure (81(8), 82(8)) comprises a plurality of first shielding structures (81(8)) and a plurality of second shielding structures (82(8)), each of the first shielding structures (81(8)) extends in a first direction, each of the second shielding structures (82(8)) extends in a second direction, the first direction intersects with the second direction and the first direction and the second direction are located in a plane parallel to the surface of the semiconductor substrate (6), and the plurality of first shielding structures (81(8)) and the plurality of second shielding structures (82(8)) are disposed in a grid shape, wherein each of the plurality of the first shielding structures (81(8)) and each of the plurality of the second shielding structures (82(8)) comprises a first shielding portion (84) and a second shielding portion (85),
∘ wherein the first shielding portion (84) extends in a fifth direction, and the fifth direction is perpendicular to the first direction and the second direction, and the first shielding portion (84) has at least one side facing the gate oxide layer (42),
o the second shielding portion (85) is located at an end portion of a side that is of the first shielding portion (84) and that faces the semiconductor substrate (6), and the second shielding portion (85) extends in a direction parallel to the surface of the semiconductor substrate (6) to form a protruding edge of the first shielding portion (84);
• a source (1) disposed on the side that is of the semiconductor layer (6) and that is away from the drift layer (5), and in contact with the source region (21) and a gate insulation layer (3); and
• a drain (7) disposed on a side that is of the semiconductor substrate (6) and that is away from the drift layer (5).

2. The semiconductor device according to claim 1, wherein the first shielding structure is bar-shaped, and the plurality of first shielding structures are parallel to each other and arranged at spacings of a first specified distance; and the second shielding structure is bar-shaped, and the plurality of second shielding structures are parallel to each other and arranged at spacings of a second specified distance.

3. The semiconductor device according to claim 1 or 2, wherein the groove comprises a plurality of first grooves and a plurality of second grooves, the first groove extends in a third direction, the second groove extends in a fourth direction, the third direction intersects with the fourth direction, and the plurality of first grooves and the plurality of second grooves are disposed in a grid shape.

4. The semiconductor device according to claim 3, wherein the first direction is the same as the third direction, and the second direction is the same as the fourth direction.

5. The semiconductor device according to claim 4, wherein at least one of the first shielding structures is disposed between any two adjacent first grooves, and at least one of the second shielding structures is disposed between any two adjacent second grooves.

6. The semiconductor device according to any one of claims 1 to 5, wherein the first direction is perpendicular to the second direction.

7. The semiconductor device according to any one of claims 1 to 6, wherein the semiconductor layer further comprises a first semiconductor region , wherein the first semiconductor region is a p-type semiconductor region, and the well region is also a p-type semiconductor region; the well region is in contact with the shielding structure, the source region, and the first semiconductor region, and the first semiconductor region is further in contact with the source; and a doping concentration of the first semiconductor region is greater than a doping concentration of the shielding structure.

8. The semiconductor device according to claim 7, wherein an orthographic projection of the first semiconductor region on the semiconductor substrate coincides with an orthographic projection of an overlapping region between the first shielding structure and the second shielding structure on the semiconductor substrate.

9. The semiconductor device according to claim 7, wherein an orthographic projection of the first semiconductor region on the semiconductor substrate coincides with an orthographic projection of the shielding structure on the semiconductor substrate.

10. The semiconductor device according to any one of claims 7 to 9, wherein a doping concentration of the well region is less than the doping concentration of the first semiconductor region.

11. The semiconductor device according to any one of claims 1 to 10, further comprising a current spreading layer, wherein the current spreading layer is an n-type semiconductor region, the current spreading layer is located at the drift layer and adjacent to the semiconductor layer, and a distance between the semiconductor substrate and a surface that is of the current spreading layer and that faces the semiconductor substrate is less than a distance between the semiconductor substrate and a surface that is of the groove and that faces the semiconductor substrate.

12. The semiconductor device according to any one of claims 1 to 11, wherein a distance between the semiconductor substrate and a surface that is of the shielding structure and that faces the semiconductor substrate is less than the distance between the semiconductor substrate and the surface that is of the groove and that faces the semiconductor substrate.

13. The semiconductor device according to any one of claims 1 to 12, wherein the shielding structure is symmetrically disposed on a peripheral side of the groove.

14. An integrated circuit comprising a circuit board and the semiconductor device according to any one of claims 1 to 13 that is disposed on the circuit board.

15. An electronic device comprising a housing and the integrated circuit according to claim 14, wherein the integrated circuit is disposed in the housing.

## Patentansprüche

1. Halbleitervorrichtung, umfassend:
ein n-Typ-Halbleitersubstrat (6);
eine Driftschicht (5), wobei die Driftschicht (5) auf einer Oberfläche des Halbleitersubstrats (6) angeordnet ist;
eine Halbleiterschicht (2), wobei die Halbleiterschicht (2) auf einer Oberfläche angeordnet ist, die von der Driftschicht (5) stammt und die von dem Halbleitersubstrat (2) entfernt ist, und einen Source-Bereich (21) und einen Wannenbereich (23) umfasst, wobei der Source-Bereich (21) ein n-Typ-Halbleiterbereich ist und der Source-Bereich (21) auf einer Seite, die von der Halbleiterschicht (2) stammt und die von der Driftschicht (5) entfernt ist, exponiert ist;
eine Nut (4), wobei sich eine Öffnung der Nut (4) auf einer Oberfläche befindet, die von der Halbleiterschicht (2) stammt und die von der Driftschicht (5) entfernt ist, ein Gate (41) in der Nut (4) angeordnet ist, und eine Gate-Oxidschicht (42) zwischen dem Gate (41) und einer Oberfläche der Nut (4) angeordnet ist;
eine p-Typ-Abschirmstruktur (81(8), 82(8)), wobei die Abschirmstruktur (81(8), 82(8)) an der Driftschicht (5) angeordnet ist und verwendet wird, um die Gate-Oxidschicht (42) an dem Boden der Nut (4) zu schützen, wobei der Wannenbereich (23) separat in Kontakt mit der Abschirmstruktur (81(8), 82(8)) und dem Source-Bereich (21) steht, und eine Tiefe der Abschirmstruktur (81(8), 82(8)) größer als eine Tiefe der Nut (4) ist, wobei die Abschirmstruktur (81(8), 82(8)) eine Vielzahl von ersten Abschirmstrukturen (81(8)) und eine Vielzahl von zweiten Abschirmstrukturen (82(8)) umfasst, sich jede der ersten Abschirmstrukturen (81(8)) in einer ersten Richtung erstreckt, sich jede der zweiten Abschirmstrukturen (82(8)) in einer zweiten Richtung erstreckt, die erste Richtung die zweite Richtung kreuzt, und sich die erste Richtung und die zweite Richtung in einer Ebene parallel zu der Oberfläche des Halbleitersubstrats (6) befinden, und die Vielzahl von ersten Abschirmstrukturen (81(8)) und die Vielzahl von zweiten Abschirmstrukturen (82(8)) in einer Gitterform angeordnet sind, wobei jede der Vielzahl von ersten Abschirmstrukturen (81(8)) und jede der Vielzahl von zweiten Abschirmstrukturen (82(8)) einen ersten Abschirmabschnitt (84) und einen zweiten Abschirmabschnitt (85) umfasst,
wobei sich der erste Abschirmabschnitt (84) in einer fünften Richtung erstreckt, und die fünfte Richtung senkrecht zu der ersten Richtung und der zweiten Richtung verläuft, und der erste Abschirmabschnitt (84) mindestens eine Seite aufweist, die der Gate-Oxidschicht (42) zugewandt ist,
sich der zweite Abschirmabschnitt (85) an einem Endabschnitt einer Seite befindet, die von dem ersten Abschirmabschnitt (84) stammt und die dem Halbleitersubstrat (6) zugewandt ist, und sich der zweite Abschirmabschnitt (85) in einer Richtung parallel zu der Oberfläche des Halbleitersubstrats (6) erstreckt, um eine vorstehende Kante des ersten Abschirmabschnitts (84) auszubilden;
eine Source (1), die auf der Seite angeordnet ist, die von der Halbleiterschicht (6) stammt und die von der Driftschicht (5) entfernt ist, und die mit dem Source-Bereich (21) und einer Gate-Isolierschicht (3) in Kontakt steht; und
einen Drain (7), der auf einer Seite angeordnet ist, die von dem Halbleitersubstrat (6) stammt und von der Driftschicht (5) entfernt ist.

2. Halbleitervorrichtung nach Anspruch 1, wobei die erste Abschirmstruktur stabförmig ist, und die Vielzahl von ersten Abschirmstrukturen parallel zueinander verläuft und in Abständen eines ersten vorgegebenen Abstands angeordnet ist; und die zweite Abschirmstruktur stabförmig ist, und die Vielzahl von zweiten Abschirmstrukturen parallel zueinander verläuft und in Abständen eines zweiten vorgegebenen Abstands angeordnet ist.

3. Halbleitervorrichtung nach Anspruch 1 oder 2, wobei die Nut eine Vielzahl von ersten Nuten und eine Vielzahl von zweiten Nuten umfasst, sich die erste Nut in eine dritte Richtung erstreckt, sich die zweite Nut in eine vierte Richtung erstreckt, die dritte Richtung die vierte Richtung kreuzt, und die Vielzahl von ersten Nuten und die Vielzahl von zweiten Nuten in einer Gitterform angeordnet sind.

4. Halbleitervorrichtung nach Anspruch 3, wobei die erste Richtung dieselbe wie die dritte Richtung ist und die zweite Richtung dieselbe wie die vierte Richtung ist.

5. Halbleitervorrichtung nach Anspruch 4, wobei mindestens eine der ersten Abschirmstrukturen zwischen zwei beliebigen benachbarten ersten Nuten angeordnet ist und mindestens eine der zweiten Abschirmstrukturen zwischen zwei beliebigen benachbarten zweiten Nuten angeordnet ist.

6. Halbleitervorrichtung nach einem der Ansprüche 1 bis 5, wobei die erste Richtung senkrecht zu der zweiten Richtung verläuft.

7. Halbleitervorrichtung nach einem der Ansprüche 1 bis 6, wobei die Halbleiterschicht ferner einen ersten Halbleiterbereich umfasst, wobei der erste Halbleiterbereich ein p-Typ-Halbleiterbereich ist und der Wannenbereich auch ein p-Typ-Halbleiterbereich ist; der Wannenbereich in Kontakt mit der Abschirmstruktur, dem Source-Bereich und dem ersten Halbleiterbereich steht, und der erste Halbleiterbereich ferner in Kontakt mit der Source steht; und eine Dotierungskonzentration des ersten Halbleiterbereichs größer als eine Dotierungskonzentration der Abschirmstruktur ist.

8. Halbleitervorrichtung nach Anspruch 7, wobei eine orthografische Projektion des ersten Halbleiterbereichs auf dem Halbleitersubstrat mit einer orthografischen Projektion eines Überlappungsbereichs zwischen der ersten Abschirmstruktur und der zweiten Abschirmstruktur auf dem Halbleitersubstrat übereinstimmt.

9. Halbleitervorrichtung nach Anspruch 7, wobei eine orthografische Projektion des ersten Halbleiterbereichs auf dem Halbleitersubstrat mit einer orthografischen Projektion der Abschirmstruktur auf dem Halbleitersubstrat übereinstimmt.

10. Halbleitervorrichtung nach einem der Ansprüche 7 bis 9, wobei eine Dotierungskonzentration des Wannenbereichs geringer als die Dotierungskonzentration des ersten Halbleiterbereichs ist.

11. Halbleitervorrichtung nach einem der Ansprüche 1 bis 10, ferner umfassend eine Stromverteilungsschicht, wobei die Stromverteilungsschicht ein n-Typ-Halbleiterbereich ist, sich die Stromverteilungsschicht an der Driftschicht befindet und mit der Halbleiterschicht benachbart ist, und ein Abstand zwischen dem Halbleitersubstrat und einer Oberfläche, die von der Stromverteilungsschicht stammt und die dem Halbleitersubstrat zugewandt ist, kleiner als ein Abstand zwischen dem Halbleitersubstrat und einer Oberfläche ist, die von der Nut stammt und die dem Halbleitersubstrat zugewandt ist.

12. Halbleitervorrichtung nach einem der Ansprüche 1 bis 11, wobei ein Abstand zwischen dem Halbleitersubstrat und einer Oberfläche, die von der Abschirmstruktur stammt und die dem Halbleitersubstrat zugewandt ist, kleiner als der Abstand zwischen dem Halbleitersubstrat und der Oberfläche ist, die von der Nut stammt und die dem Halbleitersubstrat zugewandt ist.

13. Halbleitervorrichtung nach einem der Ansprüche 1 bis 12, wobei die Abschirmstruktur symmetrisch auf einer peripheren Seite der Nut angeordnet ist.

14. Integrierte Schaltung, umfassend eine Leiterplatte und die Halbleitervorrichtung nach einem der Ansprüche 1 bis 13, die auf der Leiterplatte angeordnet ist.

15. Elektronische Vorrichtung, umfassend ein Gehäuse und die integrierten Schaltung nach Anspruch 14, wobei die integrierte Schaltung in dem Gehäuse angeordnet ist.

## Revendications

1. Dispositif à semi-conducteur comprenant :
• un substrat semi-conducteur de type n (6) ;
• une couche de dérive (5), dans lequel la couche de dérive (5) est disposée sur une surface du substrat semi-conducteur (6) ;
• une couche semi-conductrice (2), dans lequel la couche semi-conductrice (2) est disposée sur une surface qui est de la couche de dérive (5) et qui est éloignée du substrat semi-conducteur (2), et comprend une région source (21) et une région de puits (23), la région source (21) est une région semi-conductrice de type n, et la région source (21) est exposée sur un côté qui est de la couche semi-conductrice (2) et qui est éloigné de la couche de dérive (5) ;
• une rainure (4), dans lequel une ouverture de la rainure (4) est située sur une surface qui est de la couche semi-conductrice (2) et qui est éloignée de la couche de dérive (5), une grille (41) est disposée dans la rainure (4), et une couche d'oxyde de grille (42) est disposée entre la grille (41) et une surface de la rainure (4) ;
• une structure de blindage de type p (81(8), 82(8)), dans lequel la structure de blindage (81(8), 82(8)) est disposée au niveau de la couche de dérive (5) et est utilisée pour protéger la couche d'oxyde de grille (42) au fond de la rainure (4), dans lequel la région de puits (23) est en contact distinct avec la structure de blindage (81(8), 82(8)) et la région source (21) et une profondeur de la structure de blindage (81(8), 82(8)) est supérieure à une profondeur de la rainure (4), dans lequel la structure de blindage (81(8), 82(8)) comprend une pluralité de premières structures de blindage (81(8)) et une pluralité de secondes structures de blindage (82(8)), chacune des premières structures de blindage (81(8)) se prolonge dans une première direction, chacune des secondes structures de blindage (82(8)) se prolonge dans une deuxième direction, la première direction croise la deuxième direction et la première direction et la deuxième direction sont situées dans un plan parallèle à la surface du substrat semi-conducteur (6), et la pluralité de premières structures de blindage (81(8)) et la pluralité de secondes structures de blindage (82(8)) sont disposées en forme de grille, dans lequel chacune de la pluralité de premières structures de blindage (81(8)) et chacune de la pluralité de secondes structures de blindage (82(8)) comprend une première partie de blindage (84) et une seconde partie de blindage (85),
∘ dans lequel la première partie de blindage (84) se prolonge dans une cinquième direction, et la cinquième direction est perpendiculaire à la première direction et à la deuxième direction, et la première partie de blindage (84) a au moins un côté faisant face à la couche d'oxyde de grille (42),
∘ la seconde partie de blindage (85) est située à une partie d'extrémité d'un côté qui est de la première partie de blindage (84) et qui fait face au substrat semi-conducteur (6), et la seconde partie de blindage (85) se prolonge dans une direction parallèle à la surface du substrat semi-conducteur (6) pour former un bord saillant de la première partie de blindage (84) ;
• une source (1) disposée du côté qui est de la couche semi-conductrice (6) et qui est éloigné de la couche de dérive (5), et en contact avec la région source (21) et une couche d'isolation de grille (3) ; et
• un drain (7) disposé sur un côté qui est du substrat semi-conducteur (6) et qui est éloigné de la couche de dérive (5).

2. Dispositif à semi-conducteur selon la revendication 1, dans lequel la première structure de blindage est en forme de barre, et la pluralité de premières structures de blindage sont parallèles entre elles et agencées à des espacements d'une première distance spécifiée ; et la seconde structure de blindage est en forme de barre, et la pluralité de secondes structures de blindage sont parallèles entre elles et agencées à des espacements d'une seconde distance spécifiée.

3. Dispositif à semi-conducteur selon la revendication 1 ou 2, dans lequel la rainure comprend une pluralité de premières rainures et une pluralité de secondes rainures, la première rainure se prolonge dans une troisième direction, la seconde rainure se prolonge dans une quatrième direction, la troisième direction croise la quatrième direction, et la pluralité de premières rainures et la pluralité de secondes rainures sont disposées en forme de grille.

4. Dispositif à semi-conducteur selon la revendication 3, dans lequel la première direction est la même que la troisième direction, et la deuxième direction est la même que la quatrième direction.

5. Dispositif à semi-conducteur selon la revendication 4, dans lequel au moins l'une des premières structures de blindage est disposée entre deux quelconques premières rainures adjacentes, et au moins l'une des secondes structures de blindage est disposée entre deux quelconques secondes rainures adjacentes.

6. Dispositif à semi-conducteur selon l'une quelconque des revendications 1 à 5, dans lequel la première direction est perpendiculaire à la deuxième direction.

7. Dispositif à semi-conducteur selon l'une quelconque des revendications 1 à 6, dans lequel la couche semi-conductrice comprend également une première région semi-conductrice, dans lequel la région semi-conductrice est une région semi-conductrice de type p, et la région de puits est aussi une région semi-conductrice de type p ; la région de puits est en contact avec la structure de blindage, la région source, et la première région semi-conductrice, et la première région semi-conductrice est également en contact avec la source ; et une concentration de dopage de la première région semi-conductrice est supérieure à une concentration de dopage de la structure de blindage.

8. Dispositif à semi-conducteur selon la revendication 7, dans lequel une projection orthographique de la première région semi-conductrice sur le substrat semi-conducteur coïncide avec une projection orthographique d'une région de chevauchement entre la première structure de blindage et la seconde structure de blindage sur le substrat semi-conducteur.

9. Dispositif à semi-conducteur selon la revendication 7, dans lequel une projection orthographique de la première région semi-conductrice sur le substrat semi-conducteur coïncide avec une projection orthographique de la structure de blindage sur le substrat semi-conducteur.

10. Dispositif à semi-conducteur selon l'une quelconque des revendications 7 à 9, dans lequel une concentration de dopage de la région du puits est inférieure à la concentration de dopage de la première région semi-conductrice.

11. Dispositif à semi-conducteur selon l'une quelconque des revendications 1 à 10, comprenant également une couche de diffusion de courant, dans lequel la couche de diffusion de courant est une région semi-conductrice de type n, la couche de diffusion de courant est située au niveau de la couche de dérive et adjacente à la couche semi-conductrice, et une distance entre le substrat semi-conducteur et une surface qui est de la couche de diffusion de courant et qui fait face au substrat semi-conducteur est inférieure à une distance entre le substrat semi-conducteur et une surface qui est de la rainure et qui fait face au substrat semi-conducteur.

12. Dispositif à semi-conducteur selon l'une quelconque des revendications 1 à 11, dans lequel une distance entre le substrat semi-conducteur et une surface qui est de la structure de blindage et qui fait face au substrat semi-conducteur est inférieure à la distance entre le substrat semi-conducteur et la surface qui est de la rainure et qui fait face au substrat semi-conducteur.

13. Dispositif à semi-conducteur selon l'une quelconque des revendications 1 à 12, dans lequel la structure de blindage est disposée symétriquement sur un côté périphérique de la rainure.

14. Circuit intégré comprenant une carte de circuit imprimé et le dispositif semi-conducteur selon l'une quelconque des revendications 1 à 13 qui est disposé sur la carte de circuit imprimé.

15. Dispositif électronique comprenant un boîtier et le circuit intégré selon la revendication 14, dans lequel le circuit intégré est disposé dans le boîtier.
